# EUROPÄISCHE PATENTSCHRIFT

(11) **EP 1 187 945 B1**
(45) Veröffentlichungstag und Bekanntmachung des Hinweises auf die Patenterteilung: **05.01.2005**
(21) Anmeldenummer: 00914006.2
(22) Anmeldetag: 11.04.2000
(51) Int. Cl.: C23C 16/50, C23C 16/52

(54) **VERFAHREN ZUR PLASMAUNTERSTÜTZTEN REAKTIVEN ABSCHEIDUNG VON MATERIAL**
METHOD FOR THE PLASMA-SUPPORTED REACTIVE DEPOSITION OF A MATERIAL
PROCEDE DE DEPOT CHIMIQUE EN PHASE VAPEUR ACTIVE PAR PLASMA POUR DEPOSER UN MATERIAU

(30) Priorität: 29.04.1999 CH 79499
(43) Veröffentlichungstag der Anmeldung: 20.03.2002
(73) Patentinhaber: Unaxis Balzers Aktiengesellschaft, 9496 Balzers (LI)
(72) Erfinder: KARNER, Johann, A-6800 Feldkirch (AT); PEDRAZZINI, Mauro, FL-9492 Eschen (LI); HOLLENSTEIN, Christoph, CH-1095 Lutry (CH); FRANZ, David, CH-1004 Lausanne (CH)
(74) Vertreter: Troesch Scheidegger Werner AG
(86) Internationale Anmeldenummer: PCT/CH2000/000208
(87) Internationale Veröffentlichungsnummer: WO 2000/066806

(56) Entgegenhaltungen:
- EP-A- 0 724 026
- DE-A- 3 614 384
- US-A- 4 486 462
- SEVERENS R J ET AL: "On the effect of substrate temperature on a-Si:H deposition using an expanding thermal plasma" AMORPHOUS SILICON TECHNOLOGY - 1996. SYMPOSIUM, AMORPHOUS SILICON TECHNOLOGY - 1996. SYMPOSIUM, SAN FRANCISCO, CA, USA, 8-12 APRIL 1996, Seiten 341-346, XP000863191 1996, Pittsburgh, PA, USA, Mater. Res. Soc, USA
- ATAMANOV V M ET AL: "REDUCTION OF METALS IN A STEADY BEAM-PLASMA DISCHARGE" SOVIET PHYSICS TECHNICAL PHYSICS,US,AMERICAN INSTITUTE OF PHYSICS. NEW YORK, Bd. 49, Nr. 11, Seite 1287-1292 XP002031330

## Beschreibung

Die vorliegende Erfindung betrifft ein Verfahren nach dem Oberbegriff von Anspruch 1. Sie geht grundsätzlich davon aus, reaktiv plasmaunterstützt, d.h. durch ein PECVD-Verfahren, Materialien auf eine Abscheidungsoberfläche abzuscheiden, einerseits mit möglichst hoher Abscheidungsrate auf der Abscheidungsoberfläche, anderseits bei möglichst tiefer Temperatur dieser Oberfläche.

Wir definieren die Abscheidungsrate als die auf einer Oberfläche pro Zeiteinheit aufgetragene Materialdicke, wenn die erwähnte Oberfläche innerhalb des Vakuum-Rezipienten an einem, wie noch zu erläutern sein wird, definierten Ort angeordnet wird. Dies, weil, insbesondere in vorliegendem Zusammenhang, die pro Zeiteinheit auf eine Oberflächen-Einheit abgelegte Materialmenge vom Ort, an welchem die Oberfläche im Rezipienten angeordnet ist, abhängt.

Aus "Plasma-Enhanced Chemical Vapour Deposition of Epitaxial Silicon from Silan", S.R. Shanfield et al., 1046 B, Extended Abstracts, Vol. 83-1 (1983), May, Pennington, New Jersey, USA; XP-002056339 ist es bekannt, mittels PECVD, mit Silan als Reaktivgas, epitaxial Siliziumschichten abzulegen. Dabei ergibt sich eine Substrattemperatur zwischen 700° und 900°C. Es werden Beschichtungsraten (Fig. 3) von maximal 40 nm/min. erreicht.

Aus "Low Temperature Deposition of Microcrystalline Silicon in a Multipolar Plasma", T.D. Mantei et al., 1046 B Extended Abstracts, (1985), Oktober, No. 2, Pennington, New Jersey, USA; XP-002056340, ist es weiter bekannte, mikrokristalline Siliziumschichten durch ein PECVD-Verfahren abzulegen, mit Beschichtungsraten bis zu ca. 40 nm/min. bei 100°C Oberflächentemperatur und bis ca. 25 nm/min. bei 250°C Oberflächentemperatur.

Aus der DE-OS 36 14 384 derselben Anmelderin wie vorliegende Anmeldung ist es bekannt, mittels eines PECVD-Verfahrens unter Einsatz einer Niederspannungs-Hochbogenentladung, Beschichtungsraten von 200 nm/min. bei der Beschichtung mit Nickel auf Ni(CO)₄-Gas zu erreichen, als höchste dort angegebene Abscheidungsrate. Si wird dabei lediglich mit einer Beschichtungsrate von ca. 17 nm/min. abgelegt. Mit Hilfe der Niederspannungsentladung wird im Vakuumrezipienten ein homogen dichtes Plasma erzeugt.

Gemäss "Plasma-assisted CVD of Diamond Films by Hollow Cathode Arc Discharge", J. Stiegler et al., Diamond and Related Materials, 2 (1993), 413 - 416, ist es bekannt, durch ein PECVD-Verfahren Diamantschichten abzuscheiden mit einer Abscheidungsrate von bis zu ca. 35 nm/min bei Oberflächentemperaturen von mindestens 700°C.

Aus "Low Temperature Plasma-Enhanced Epitaxy of GaAs", K.P. Pande, 1046 Journal of the Electrochemical Society, 131 (1984), June, No. 6, Manchester, New Hampshire, USA, ist es weiter bekannt, GaAs-Epitaxieschichten abzulegen bei tiefen Temperaturen unterhalb 400°C, jedoch mit Abscheidungsraten von 80 nm/min, allerdings erst bei Temperaturen um 500°C.

Aus der US-A 5 554 222 ist es bekannt, diamantähnliche Schichten bei relativ kühlen Abscheidungsflächen-Temperaturen von 250°C wenn gekühlt, und 400°C ungekühlt, abzuscheiden. Es wird von Abscheidungsraten von 20 nm/sec berichtet.

Aus der PCT/CH98/00221 derselben Anmelderin wie vorliegende Anmeldung, ist es weiter bekannt, mittels PECVD-Verfahren Abscheidungsraten von ca. zwischen 100 und 200 nm/min. zu erzielen, bei Oberflächentemperaturen je nach Abscheidungsmaterial zwischen 300° und 800°C.

Aus Severens R.J. et al "ON THE EFFECT OF SUBSTRATE TEMPERATURE ON a-Si:H DEPOSITION USING AN EXPANDING THERMAL PLASMA" Mat. Res. Soc. Symp. Proc. Vol. 420, 1996 Materials Research Society, Page 341 to 346 ist ein Verfahren bekannt zur Herstellung von amorphem Silizium, bei welchem Abscheidungsraten von 420 nm/min. erreicht werden, bei einer Abscheidungsoberflächentemperatur von 350°C bzw. optimal von 250°C. Es wird ein Plasmastrahl, der in einer vom Behandlungsrezipienten abgesetzten Kammer erstellt wird, eingesetzt, und in den Behandlungsrezipienten gesprüht. Das Substrat wird rechtwinklig zur Strahlachse und diesbezüglich zentriert der Behandlung ausgesetzt.

Ausgehend von diesem vorbekannten Verfahren zur Herstellung amorphen Siliziums stellt sich die vorliegende Erfindung zur Aufgabe, mikrokristallines Silizium abzuscheiden, unter Beibehalt der hohen Abscheidungsrate und tiefen Abscheidungstemperatur.

Dies wird durch die Ausführung des Verfahrens genannter Art nach dem Kennzeichen von Anspruch 1 erreicht.

Aus der EP 0 724 026 derselben Anmelderin wie vorliegende Erfindung ist nämlich ein Verfahren zur reaktiven Behandlung von Werkstücken, bei dem ein Plasmastrahl in einem evakuierten Rezipienten erzeugt wird und, bezüglich des Bereiches höchster Plasmadichte entlang der Strahlachse radial versetzt, Werkstücke angeordnet werden, wobei frisches Reaktivgas in den Rezipienten eingelassen und verbrauchtes aus dem Rezipienten ausgeaugt wird und bei dem weiter gleich zu behandelnde Werkstückoberflächen entlang einer längsausgedehnten Rotationsfläche verteilt um den Plasmastrahl angeordnet werden, und zwar derart, dass die Plasmadichte an den Oberflächen höchstens 20% der maximalen Strahlplasmadichte beträgt, jeweils in Ebenen senkrecht zur Strahlachse betrachtet, bekannt, welches sich zur Abscheidung von schwierig herstellbaren, metastabilen Schichten insbesondere von Diamant-, cBN-, α-Al₂O₃- oder C₃N₄-Schichten eignet. Dabei wurde in dieser Schrift erkannt, dass sich der Diffusionsbereich von Hochstrombogenentladungen, d.h. der Bereich mit einer Plasmadichte ≤ 20% der Strahlzentrums-Plasmadichte, ausserordentlich gut für die Abscheidung von extrem harten Schichten eignet, insbesondere für die Abscheidung von Schichten aus unter Normalbedingungen schwierig herstellbaren, metastabilen Phasen, wie der obgenannten.

Es wurde nun gemäss vorliegender Erfindung erkannt, dass sich dieses Vorgehen nicht nur für die Abscheidung schwierig herstellbarer Schichten eignet, sondern erstaunlicherweise für das Abscheiden mikrokristallinen Siliziums mit sehr hohen Abscheidungsraten und, wie erwähnt, unter Einhalt tiefer Temperaturen.

Dabei eignet sich das erfindungsgemässe Verfahren ganz besonders für das Ablegen von µc-Si:H.

Insbesondere hierbei wurde erkannt, dass mit dem Gehalt an Wasserstoff in der Prozessatmosphäre die Temperaturen der behandelten Werkstücke in einem weiten Bereich, so zwischen Temperaturen über 400°C bis zu Temperaturen über 250°C eingestellt werden können. Je geringer der Wasserstoffanteil ist, desto tiefer die erwähnte Temperatur. Weil nun dieser H₂-Gehalt bei der Bildung von µc-Si:H nicht besonders kritisch ist, ist diese Grösse besonders beim Ablegen dieses Materials höchst geeignet, als Temperatur-Stellgrösse eingesetzt zu werden.

Es ist dabei zu betonen, dass sich aus dem vorbekannten Verfahren für sehr harte Schichten und insbesondere für die erwähnten, schwierig herstellbaren metastabilen Phasen keinesfalls ergibt, dass sich dieses Verfahren für die Hochraten-Abscheidung eignet, im Gegenteil.

Es wird der Plasmastrahl, wohl wie in der EP 0 724 026 beschrieben als Niedervolt-Bogenentladung jedoch mit einem Bogenstrom von 80 - 170A betrieben.

Die Abscheidung erfolgt als Beschichtungsabscheidung oder als Abscheidung in Pulver- oder Clusterform, d.h., in letzterwähntem Fall, zur Gewinnung des mikrokristallinen Siliziums in Pulver- bzw. Clusterform. Um im Weiteren die erwähnte Abscheidung mit möglichst grossem Wirkungsgrad vorzunehmen, d.h. genutzte abgeschiedene Materialmengen pro eingelassene Reaktivgasmenge, wird weiter vorgeschlagen, dass man die Abscheidungsoberfläche entlang Rotationsflächen um die Strahlachse anordnet.

Zum Erzielen eines möglichst hohen Wirkungsgrades bezüglich abgeschiedener Materialmengen und eingelassenem Reaktivgas wird weiter vorgeschlagen, die Abscheidungsoberfläche, sei dies gebildet durch eine Auffangfläche für abgeschiedenes Pulver oder Cluster, sei dies gebildet durch zu beschichtende Werkstückoberflächen, ringförmig um die Achse des Plasmastrahles anzuordnen.

Insbesondere, wenn, wie beim Einsatz der erfindungsgemässen Verfahrens für Oberflächenbeschichtung, die Abscheidungsdicken-Homogenität ein wesentliches Kriterium ist, wird weiter vorgeschlagen, die Abscheidungsoberfläche um die Strahlachse und/oder jeweils um eine von der Strahlachse versetzte, vorzugsweise hierzu parallele Rotationsachse während der Abscheidung zu drehen.

Eine Homogenisierung der Abscheidungsverteilung wird bereits durch die zur Strahlachse im Wesentlichen parallel erstellte Reaktivgasströmung im Rezipienten erreicht.

In einer weiteren, weitaus bevorzugten Ausführungsform des erfindungsgemässen Verfahrens wird die Plasmadichteverteilung mittels eines im Wesentlichen parallel zur Strahlachse erzeugten Magnetfeldes gesteuert. Wenn ein solches Feld angelegt wird, so bevorzugt von höchstens 250 Gauss, vorzugsweise von 100 Gauss, insbesondere bevorzugt von 60 Gauss.

Dabei kann, je nach Einsatzzweck, die Abscheidungsoberfläche potential-fliegend oder auf ein vorzugsweise einstellbares elektrisches Potential gelegt werden, dabei auf ein DC-, ein AC- oder ein AC+DC-Potential.

Der Plasmastrahl wird weiter in einer bevorzugten Ausführungsform als Hochstrombogenentladung mittels einer Kaltkathodenoder mit einer Heisskathodenentladung mit Kathodenkammer und Austrittsblende erzeugt. Weitaus bevorzugt und für die Ausbildung insbesondere der Niederspannungs/Hochstrom-Bogenentladung wesentlich ist es, den Gesamtdruck im Rezipienten auf mindestens 1 mbar zu halten.

Bevorzugt wird Silan als reaktives Gas eingesetzt. Insbesondere wesentlich ist dabei auch, dass erfindungsgemäss mikrokristallines Silizium in nm- bis µm-Pulver- bzw. Clusterform abgelegt werden kann. Im Weiteren lassen sich mit der erwähnten hohen Abscheidungsrate, als Schicht oder Pulver, weiter Siliziumverbindungen abscheiden, wie SiC, SiN. Es ergibt sich bei der Abscheidung als Beschichtung trotz der hohen Abscheidungsraten eine sich für Epitaxie-Schichtbildung eignende hohe Beschichtungsqualität.

Im Weiteren werden bevorzugterweise mit den erfindungsgemässen Verfahren industriell weit verbreitete Silizium- oder Glassubstrate beschichtet.

Die Erfindung wird anschliessend beispielsweise anhand von Figuren und Beispielen erläutert, wobei bezüglich auch eingesetztem, vorbekanntem Vorgehen auf die integrierter Bestandteil der vorliegenden Beschreibung bildende EP-A-0 724 026 verwiesen sei. In den Fig. zeigen:
- Fig. 1: schematisch, einen Hochstrombogen und die diesbezügliche erfindungsgemässe Anordnung von Abscheidungsoberflächen,
- Fig. 2: schematisch, eine verwendete Anlage für die erfindungsgemässe Abscheidung mikrokristallinen Siliziums,

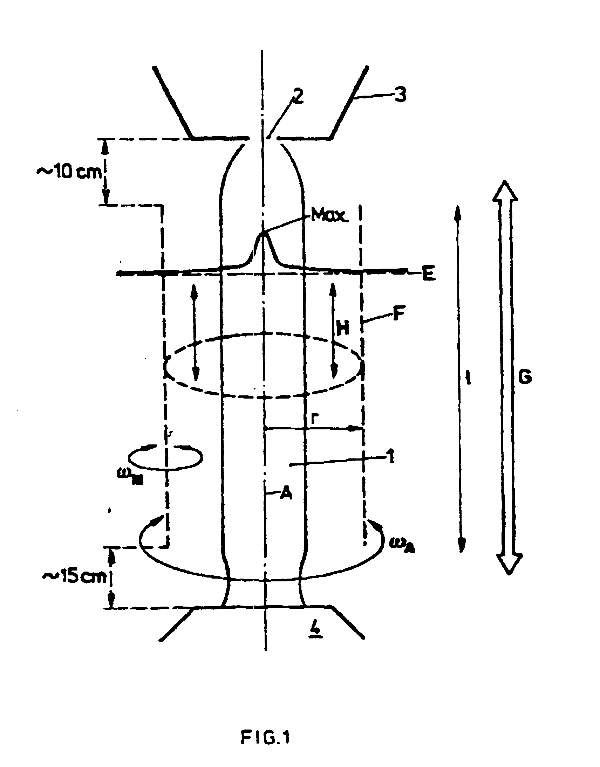

Anhand von Fig. 1 soll vorerst das grundsätzliche Vorgehen gemäss der vorliegenden Erfindung erläutert werden. Der bevorzugt als Hochstrombogen 1 ausgebildete Plasmastrahl divergiert nach einer Blendenöffnung 2 einer Kathodenkammer 3 rasch, innerhalb einiger cm, auf eine bestimmte Ausdehnung, um dann eine weitgehend konstante Ausbildung bis knapp vor die Anode, bis einige cm davor, beizubehalten. Die Ausdehnung des Bogens vor der Anode ist von der geometrischen Form der Anode abhängig. Damit ergibt sich bis auf einen kleinen Bereich nach der Blendenöffnung 2 und über der Anode 4, ein weitgehend homogener, langer Bereich 1 des Hochstrombogens. Entlang der Achse A ergeben sich, in diametralen Schnittebenen E, wie beispielsweise eingetragen, Glockenkurven-förmige Verteilungen der Plasmadichte. In jeder Ebene E weist die Plasmadichteverteilung eine Maximalstelle Max. auf.

Für das erfindungsgemässe Verfahren beträgt die Bogenlänge bevorzugterweise zwischen 50 und 120 cm, insbesondere bevorzugt ca. 90cm.

Es wird weiter für das erfindungsgemässe Verfahren der Totaldruck im Rezipienten zu mehr als 1 mbar gewählt. Die erfindungsgemäss vorzusehenden Oberflächen zur Abscheidung von Materialien werden bevorzugt in einem Radius r von der Strahlachse A angeordnet, woran noch höchstens eine Plasmadichte von 20% vorherrscht.

Die Breite des Plasmastrahls und damit auch die Plasmadichteverteilung wird über Stellen des Bogenstromes und/oder insbesondere über ein axiales Magnetfeld H, wie in Fig. 1 dargestellt, gemäss den jeweiligen Bedürfnissen eingestellt.

Dabei wird ein die Feldstärke bevorzugt zu höchstens 250 Gauss, aber insbesondere zu höchstens 100 Gauss, ganz besonders bevorzugt aber zwischen 0 Gauss (ohne Feld) und 60 Gauss eingestellt.

Durch die Anordnung der Abscheidungsoberflächen im Bereich geringer Plasmadichte ergibt sich auch der Vorteil, dass diese entlang paralleler Geraden zu der Strahlachse und im homogenen Bereich 1 nur geringfügig variiert.

Hierzu wird der Abstand r der zu behandelnden Werkstückoberflächen von der Strahlachse A bevorzugt gewählt zu
6 cm ≤ r ≤ 20 cm, insbesondere zu
9 cm ≤ r ≤ 13 cm.

Wie weiter in Fig. 1 dargestellt, werden grössere einzusetzende Abscheidungsflächen und insbesondere derartige Flächen, woran eine Beschichtung zu erzeugen ist, bevorzugterweise zu Achsen parallel zur Strahlachse, wie mit ω_{M} dargestellt ist, pendelnd oder umlaufend bewegt und/oder ggf. um die Strahlachse A, wie mit ω_{A} dargestellt, gedreht. Im Weiteren wird bevorzugt der Reaktivgasfluss, wie mit G dargestellt, im Wesentlichen parallel zur Strahlachse A erzeugt.

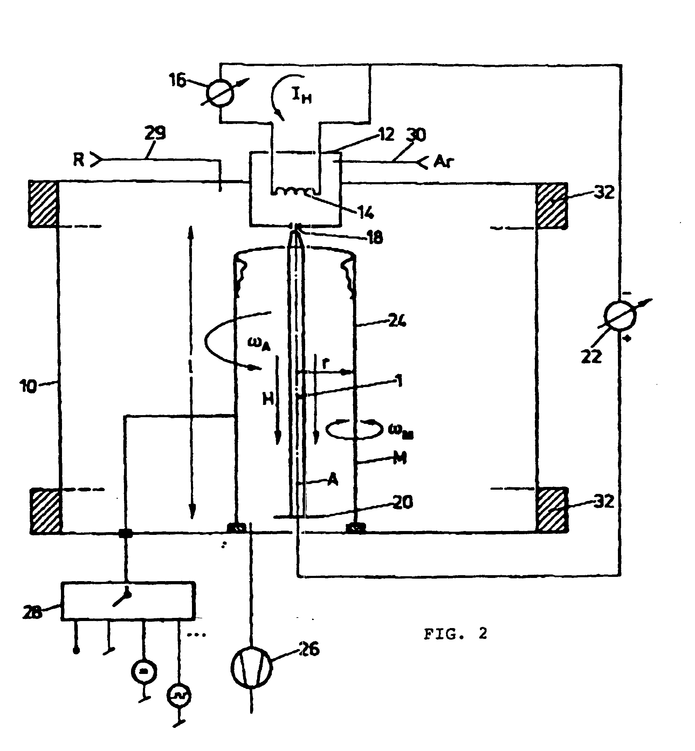

In Fig. 2 ist eine Anlage schematisch dargestellt. In einem Vakuumrezipienten 10 wird der Plasmastrahl 1 vorzugsweise als Hochstrombogenentladung erzeugt, vorzugsweise in Form einer Heisskathoden-Niederspannungs-Hochstrombogenentladung, wobei aber auch eine Kaltkathoden-Bogenentladung eingesetzt werden kann.

Am Vakuumrezipienten 10 ist eine Kathodenkammer 12 angeflanscht mit einer elektronenemittierenden Heisskathode 14, die in einen Heizstromkreis für den Heizstrom I_{H} mit vorzugsweise einstellbarem Heizstromgenerator 16 geschaltet ist.

Gegenüber einer an der Kathodenkammer 12 vorgesehenen Strahlaustrittsblende 18 ist die Anode 20 angeordnet. Zwischen Heisskathode 14 bzw. Heizstromkreis und Anode ist der vorzugsweise einstellbare Entladungsgenerator 22 geschaltet. Bezüglich Details dieser bekannten Anordnung kann nebst auf die EP-0 724 026 auch auf die CH 664 768 verwiesen werden.

Es ist eine zylindrische Fläche definierende Werkstückträgeranordnung 24 vorgesehen für mit der erfindungsgemässen Verwendung zu beschichtende Abscheidungsoberflächen oder als Auffangfläche für die Abscheidung von Materialpulver bzw. -Cluster. Der Radius r ist, wie aus obigen Erläuterungen erkenntlich wurde, Strahlleistungs-abhängig.

Entlang der zylindrischen Werkstückträgeranordnung, unter Einhalt der erwähnten Plasmadichtebedingungen, werden zu beschichtende Werkstücke, wie in bevorzugter Ausführungsform Glas- oder Silizium-Substrate, vorgesehen für die Hochratenabscheidung von mikrokristallinem Silizium. Es können aber auch andere Werkstücke, wie Werkzeuge, beispielsweise Bohrer, Wendeschneidplatten, Fräser etc. daran angeordnet werden, um sie mit Hartstoffschichten, wie Schichten aus TiN, TiAlN, Si-Al-ON, SiC, SiN etc. zu beschichten, oder mit Schichten mit geringem Reibungskoeffizienten, wie mit Schichten aus CrC, FeC, WCC, also z.B. Metall-Kohlenstoff-Schichten. Um die Reaktivgase möglichst effizient auszunützen, werden ggf. vorgesehene Substratträger möglichst transparent gebaut, so dass die Hauptfläche durch die Werkstücke bzw. Substrate selbst und nicht durch deren Halterungen gebildet wird.

Wie aus Fig. 2 weiter ersichtlich, wird Reaktivgas R, für die bevorzugte Ausführung, nämlich die Abscheidung von mikrokristallinem Silizium, bevorzugterweise Silan, kathodenseitig bei 29 in den Rezipienten 10 eingelassen, anodenseitig ist die Pumpenanordung 26 vorgesehen. Dadurch wird eine im Wesentlichen parallel zur Achse A gerichtete Gasströmung durch den Rezipienten und entlang der auf einer Zylinderfläche liegenden Abscheidungsoberfläche 24 erstellt. über eine Trägeranordnung werden Werkstücke oder generell Abscheidungsoberflächen potential-fliegend betrieben oder auf ein Bezugspotential, beispielsweise Massepotential, gelegt, oder auf ein DC-Biaspotential, ein ACoder ein gemischtes AC+DC-Potential gelegt, wie beispielsweise auf ein gepulstes DC-Potential. Diese und weitere Potentiallegungs-Möglichkeiten für die Abscheidungsflächen sind in Fig. 2 schematisch mit der Umschalteinheit 28 dargestellt. Die Anlage gemäss Fig. 2 wurde für die Beispiele 1 bis 6 gemäss nachfolgender Tabelle beschichtet.

| | | Beispiel 1 | Beispiel 2 | Beispiel 3 (vgl.) |
|---|---|---|---|---|
| Verfahrensparameter | | | | |
| Bogenstrom | [A) | 100 | 160 | 400 |
| Magnetfeld | [Gauss] | 50 | 80 | 60 |
| Gesamtdruck | [mbar) | 1,5 | 1,5 | 2,0 |
| Gasflüsse | [sccm] | | | |
| Ar | | 1.800 | 1.800 | 1.800 |
| H₂ | | 20 | 50 | 40 |
| SiH₄ | | 60 | 100 | 100 |
| Abstand v. Bogenachse | [cm] | 16 | 10 | 16 |
| Substrattemperatur | [°C] | 250 | 350 | 450 |
| Beschichtungszeit | [min] | 40 | 80 | 20 |
| Wachstumsrate | [nm/min.] | 450 | 600 | 600 |
| Bogenlänge | [cm] | 90 | 90 | 90 |
| | | | | |

| Schichteigenschaften | | | | |
|---|---|---|---|---|
| Schichtdicke | [µm] | 18 | 48 | 12 |
| Kristallstruktur | | µc-Si:H | µc-Si:H | µc-Si:H |
| | | | | |
| | | | | |

| | | Beispiel 4 | Beispiel 5 | Beispiel 6 |
|---|---|---|---|---|
| Verfahrensparameter | | | | |
| Bogenstrom | [A] | 120 | 120 | 120 |
| Magnetfeld | [Gauss] | 0 | 0 | 30 |
| Gesamtdruck | [mbar] | 1,5 | 1,5 | 1,5 |
| Gasflüsse | [sccm] | | | |
| Ar | | 2.700 | 2.700 | 2.700 |
| H₂ | | 50 | 40 | 0 |
| SiH₄ | | 75 | 80 | 100 |
| Abstand v. Bogenachse | [cm] | 7 | 10 | 9 |
| Substrattemperatur | [°C) | 450 | 400 | 420 |
| Beschichtungszeit | [min] | 16 | 25 | 24 |
| Wachstumsrate | [nm/min.] | 630 | 400 | 500 |
| Bogenlänge | [cm] | 50 | 50 | 50 |
| | | | | |

| Schichteigenschaften | | | | |
|---|---|---|---|---|
| Schichtdicke | [µm) | 10 | 10 | 10 |
| Kristallstruktur | | µc-Si:H | µc-Si:H | µc-Si:H |

Bei allen Beispielen wurden µc-Si:H-Strukturen abgeschieden, direkt auf die eingesetzten Glas- oder Siliziumsubstrate. Die Schichten wiesen teilweise epitaktische Qualität auf. Zu bemerken ist, dass bei keiner der Schichten eine amorphe Zwischenschicht direkt auf dem Substrat entstand. Dies ist ungewöhnlich, da doch bei herkömmlichen Beschichtungsverfahren normalerweise immer erst eine amorphe Siliziumzwischenschicht, die dann ein Aufwachsen epitaktischer Schichten verhindert, entsteht. Damit zeigt sich, dass das erfindungsgemäss eingesetzte Verfahren sich auch für die Abscheidung epitaktischer Schichten eignet. Auffällig ist weiter die extrem hohe Wachstumsrate, die auch bei tiefen Abscheidungstemperaturen erzielt wird.

Generell können für die erfindungsgemässe Verwendung folgende Betriebsgrössen angegeben werden:

| | |
|---|---|
| Bogenstrom | 80 - 170 A |
| | |
| Totaldruck | 1 mbar ≤ Pₜₒₜ ≤ 3 mbar |
| | |
| Axiales Magnetfeld H | 0 - 250 Gauss, vorzugsweise 0 - 100 Gauss, besonders angeraten 0 - 60 Gauss. |

Abstand Strahlachse zu Werkstückoberfläche r:
6 cm ≤ r ≤ 20 cm,
bevorzugt 9 cm ≤ r ≤ 13 cm.

Für die Abscheidung von mikrokristallinem Silizium, wurden weiter, bei einer Rezipientengrösse von ca. 80 l und einer wie angegeben bemessenen Bogenlänge von 90 cm gemäss obigen Beispielen, folgende Gasflüsse eingesetzt:

| | |
|---|---|
| Argon | 1800 sccm |
| | |
| H₂ | 0 - 100 sccm |
| | |
| Silan, SiH₄ | 5 - 100 sccm |

Substrattemperaturen werden erreicht, die nicht höher als 450°C liegen, üblicherweise zwischen 250 und 500°C.

Je nach eingestelltem Bogenstrom ergeben sich zum Einhalt der Plasmadichte-Bedingungen, bevorzugt von höchstens 20 % der Maximaldichte an der Strahlachse, radiale Abstände von der Strahlachse zwischen 6 und 20 cm, bevorzugt, wie erwähnt wurde von 9 bis 13 cm.

Je nach Einstellung der Betriebsparameter ergeben sich beim Abscheiden mikrokristallinen Siliziums die erwähnten Schichten als Beschichtungen oder aber Abscheidungen in Form von Pulver bzw. Clustern in nm- bis µm-Grösse.

In Funktion des Wasserstoffgehaltes der Behandlungsatmosphären wurde weiter bei einem Totaldruck von 1,5 mbar, ohne angelegtes Magnetfeld, weiter mit r = 10 cm, einem Bogenstrom von 120 A sowie einem konstanten Argonfluss von 1'800 sccm folgende Abhängigkeit gemessen:

| **H**_{**2**}**-Fluss (sccm)** | **Temperatur an Ascheidungsoberfläche (°C)** |
|---|---|
| 10 | 220 |
| 30 | 270 |
| 50 | 310 |
| 70 | 350 |
| 100 | 390 |
| 150 | 450 |

Daraus ist ersichtlich, dass sich der Wasserstoffgehalt in der Behandlungsatmosphäre ausgezeichnet dazu eignet, die Abscheidungstemperatur an den Werkstückoberflächen einzustellen.

## Patentansprüche

1. Verfahren zur Herstellung von Silizium durch reaktives Abscheiden unter Einhalt einer Abscheidungsrate von mindestens 400 nm/min bei einer Abscheidungsoberflächentemperatur von höchstens 550°C mit Hilfe eines Plasmastrahls, wobei weiter frisches Reaktivgas in den Behandlungsrezipienten derart eingelassen und verbrauchtes derart aus dem Rezipienten abgesaugt wird, dass eine im Wesentlichen zur Strahlachse parallele Gasströmung entsteht, **dadurch gekennzeichnet, dass** der Plasmastrahl an einer Entladungsstrecke in einem evakuierten Rezipienten erzeugt wird mit einem Bogenstrom von 80 bis 170 A und die Abscheidungsoberfläche entlang der Strahlachse diesbezüglich radial versetzt angeordnet wird und dabei mikrokristallines Silizium abgelegt wird.

2. Verfahren nach Anspruch 1, **dadurch gekennzeichnet, dass** das mikrokristalline Silizium als Oberflächenbeschichtung oder in Pulver- bzw. Clusterform abgeschieden wird.

3. Verfahren nach einem der Ansprüche 1 oder 2, **dadurch gekennzeichnet, dass** die Abscheidungsoberfläche um die Strahlachse gedreht und/oder um eine bezüglich der Strahlachse versetzte, vorzugsweise diesbezüglich parallele Achse gedreht oder pendelnd geschwenkt wird.

4. Verfahren nach einem der Ansprüche 1 bis 3, **dadurch gekennzeichnet, dass** die Plasmadichteverteilung mittels eines im Wesentlichen achsparallelen Magnetfeldes eingestellt wird, dabei bevorzugt zwischen 0 (kein Feld) und 0.025 T (250 Gauss) insbesondere bevorzugt von höchstens 0.01 T (100 Gauss) ganz besonders bevorzugt zwischen 0 (kein Feld) und 0.006 T (60 Gauss).

5. Verfahren nach einem der Ansprüche 1 bis 4, **dadurch gekennzeichnet, dass** der Plasmastrahl als Hochstrombogen mittels einer Kaltkathode- oder mit einer Heisskathodeentladung mit Kathodenkammer mit Austrittsblende erzeugt wird.

6. Verfahren nach einem der Ansprüche 1 bis 5, **dadurch gekennzeichnet, dass** die Abscheidungsoberfläche potential-fliegend oder auf einem vorzugsweise einstellbaren elektrischen Potential, dabei auf einem DC-, einem AC-, oder einem AC+DC-Potential betrieben wird.

7. Verfahren nach einem der Ansprüche 1 bis 6, **dadurch gekennzeichnet, dass** man die Plasmastrahllänge zu mehr als 50 cm wählt.

8. Verfahren nach einem der Ansprüche 1 bis 7, **dadurch gekennzeichnet, dass** mikrokristallines Silizium µc-Si:H, bevorzugt unter Verwendung von Silan als Reaktivgas, abgeschieden wird.

9. Verfahren nach einem der Ansprüche 1 bis 8, **dadurch gekennzeichnet, dass** die Abscheidung auf Glas- oder Siliziumwafern vorgenommen wird.

10. Verfahren nach einem der Ansprüche 1 bis 9, **dadurch gekennzeichnet, dass** die Abscheideoberfläche in einem Abstand r von der Plasmastrahlachse angeordnet wird, für den gilt:
6 cm ≤ r ≤ 20 cm,
bevorzugt 9cm ≤ r ≤ 13 cm.

11. Verfahren nach einem der Ansprüche 1 bis 10, **dadurch gekennzeichnet, dass** im Rezipienten ein Totaldruck Pₜₒₜ von
1 mbar ≤ Pₜₒₜ ≤ 3 mbar
erstellt wird.

12. Verfahren nach einem der Ansprüche 1 bis 11, **dadurch gekennzeichnet, dass** die Abscheidungsoberfläche in einem Plasmadichtebereich von höchstens 20 % der maximalen Plasmadichte in der Strahlachse angeordnet wird.

## Claims

1. Method for the production of silicon by reactive deposition while retaining a deposition rate of at least 400 nm/min at a deposition surface temperature of maximum 550°C with the aid of a plasma beam, where furthermore fresh reactive gas is introduced into the treatment recipient and consumed gas is exhausted from the recipient such that a gas stream is generated substantially parallel to the beam axis, **characterised in that** the plasma beam is generated on a discharge path in an evacuated recipient with an arc current of 80 to 170 A and the deposition surface is arranged radially offset along the beam axis in respect of this and micro-crystalline silicon is deposited.

2. Method according to claim 1, **characterised in that** the micro-crystalline silicon is deposited as a surface coating or in powder or cluster form.

3. Method according to one of claims 1 or 2, **characterised in that** the deposition surface is rotated about the beam axis and/or rotated or swivelled oscillating about an axis offset in relation to the beam axis, preferably parallel thereto.

4. Method according to any of claims 1 to 3, **characterised in that** the plasma density distribution is set by means of an essentially axis-parallel magnetic field, preferably between 0 (no field) and 0.025 T (250 Gauss), particularly preferably maximum 0.01 T (100 Gauss), and quite particularly preferably between 0 (no field) and 0.006 T (60 Gauss).

5. Method according to any of claims 1 to 4, **characterised in that** the plasma beam is generated as a high current arc by means of a cold cathode or a hot cathode discharge with cathode chamber and exit screen.

6. Method according to any of claims 1 to 5, **characterised in that** the deposition surface is operated potential-floating or on a preferably adjustable electrical potential, thereby on a DC, an AC, or an AC+DC potential.

7. Method according to any of claims 1 to 6, **characterised in that** the plasma beam length is selected as more than 50 cm.

8. Method according to any of claims 1 to 7, **characterised in that** micro-crystalline silicon µc-Si:H is deposited, preferably by using silane as the reactive gas.

9. Method according to any of claims 1 to 8, **characterised in that** the deposition is made onto glass or silicon wafers.

10. Method according to any of claims 1 to 9, **characterised in that** the deposition surface is arranged at a distance r from the plasma beam axis, for which:
6 cm ≤ r ≤ 20 cm,
preferably:
9cm ≤ r ≤ 13 cm.

11. Method according to any of claims 1 to 10, **characterised in that** in the recipient is created a total pressure Pₜₒₜ of
1 mbar ≤ Pₜₒₜ ≤ 3 mbar.

12. Method according to any of claims 1 to 11, **characterised in that** the deposition surface is arranged in a plasma density range of maximum 20% of the maximum plasma density in the beam axis.

## Revendications

1. Procédé pour fabriquer du silicium par dépôt réactif en respectant une vitesse de dépôt d'au moins 400 nm/min à une température superficielle du dépôt maximale de 550°C à l'aide d'un jet de plasma, un gaz réactif frais étant introduit dans le récipient de traitement et le gaz réactif consommé étant aspiré hors du récipient de telle sorte qu'il se forme un écoulement de gaz sensiblement parallèle à l'axe du jet, **caractérisé en ce que** le jet de plasma est généré sur une voie de décharge dans un récipient évacué, avec un courant d'arc de 80 à 170 A, et la surface du dépôt est disposée de manière décalée radialement le long de l'axe du jet par rapport à celui-ci, et du silicium microcristallin étant ainsi déposé.

2. Procédé selon la revendication 1, **caractérisé en ce que** le silicium microcristallin est déposé sous la forme d'un revêtement superficiel ou sous la forme de poudre ou d'un agglomérat.

3. Procédé selon la revendication 1 ou 2, **caractérisé en ce que** la superficie du dépôt tourne autour de l'axe du jet et/ou est soumise à une rotation ou à un pivotement alternatif autour d'un axe décalé par rapport à l'axe du jet, de préférence parallèle à celui-ci.

4. Procédé selon l'une des revendications 1 à 3, **caractérisé en ce que** la répartition de la. densité de plasma est réglée à l'aide d'un champ magnétique sensiblement parallèle à l'axe, de préférence entre 0 (aucun champ) et 0,025 T (250 Gauss), plus spécialement de 0,01 T (100 Gauss) au maximum et tout spécialement entre 0 (aucun champ) et 0,006 T (60 Gauss).

5. Procédé selon l'une des revendications 1 à 4, **caractérisé en ce que** le jet de plasma est généré sous la forme d'un arc à haute intensité à l'aide d'une décharge de cathode froide ou chaude, avec une chambre à cathode pourvue d'une ouverture de sortie.

6. Procédé selon l'une des revendications 1 à 5, **caractérisé en ce que** la superficie du dépôt fonctionne à un potentiel flottant ou à un potentiel électrique de préférence réglable, à courant continu, alternatif ou continu+alternatif.

7. Procédé selon l'une des revendications 1 à 6, **caractérisé en ce qu'**on choisit une longueur de jet de plasma supérieure à 50 cm.

8. Procédé selon l'une des revendications 1 à 7, **caractérisé en ce que** du silicium microcristallin µc-Si:H est déposé, de préférence à l'aide de silane comme gaz réactif.

9. Procédé selon l'une des revendications 1 à 8, **caractérisé en ce que** le dépôt est réalisé sur des plaquettes de verre ou de silicium.

10. Procédé selon l'une des revendications 1 à 9, **caractérisé en ce que** la superficie du dépôt est disposée à une distance r de l'axe du jet de plasma :
6 cm ≤ r ≤ 20 cm,
de préférence
9 cm ≤ r ≤ 13 cm.

11. Procédé selon l'une des revendications 1 à 10, **caractérisé en ce qu'**on établit dans le récipient une pression totale Pₜₒₜ
1 mbar ≤ Pₜₒₜ ≤ 3 mbar.

12. Procédé selon l'une des revendications 1 à 11, **caractérisé en ce que** la superficie du dépôt est disposée dans l'axe du jet dans une plage de densité de plasma égale au maximum à 20 % de la densité de plasma maximale.
